# EUROPÄISCHE PATENTSCHRIFT

(11) **EP 0 920 709 B1**
(45) Veröffentlichungstag und Bekanntmachung des Hinweises auf die Patenterteilung: **01.03.2000**
(21) Anmeldenummer: 97935493.3
(22) Anmeldetag: 23.07.1997
(51) Int. Cl.: H01J 37/145

(54) **ELEKTRONENOPTISCHE LINSENANORDNUNG MIT SPALTFÖRMIGEM ÖFFNUNGSQUERSCHNITT**
ELECTRON OPTICAL LENS SYSTEM WITH A SLOT-SHAPED APERTURE CROSS SECTION
SYSTEME DE LENTILLES ELECTRONO-OPTIQUE POURVU D'UNE SECTION D'OUVERTURE EN FORME DE FENTE

(30) Priorität: 26.08.1996 DE 19634456
(43) Veröffentlichungstag der Anmeldung: 09.06.1999
(73) Patentinhaber: Spehr, Rainer, 64372 Ober-Ramstadt (DE)
(72) Erfinder: Spehr, Rainer, 64372 Ober-Ramstadt (DE)
(74) Vertreter: Pöhner, Wilfried Anton, Dr.
(86) Internationale Anmeldenummer: DE9701588
(87) Internationale Veröffentlichungsnummer: WO9809313

(56) Entgegenhaltungen:
- DE-A- 2 623 337
- DE-A- 4 105 121
- FR-A- 2 350 686

## Beschreibung

Die Erfindung betrifft eine Linsenanordnung, insbesondere zur Fokussierung von Elektronen, mit einer Zylinderlinse, welche mit Polschuhen oder Elektroden versehen ist, zwischen denen eine Öffnung befindlich ist, die einen spaltförmigen Querschnitt senkrecht der optischen Achse der Linse aufweist.

Mit Hilfe der Elektronenstrahl-Lithographie lassen sich Strukturen minimaler Größe erzeugen, wobei ein wesentliches Anwendungsfeld die Herstellung elektronischer Bauelemente und integrierter Schaltungen auf der Oberfläche scheibenförmiger Halbleiterkristalle (Wafer) ist. Zur Fokussierung der Elektronen werden Elekronenlinsen benötigt, die eine kurze Brennweite aufweisen und deren nutzbares Schreibfeld (d. h. der Bereich, in dem der Brennpunkt parallel der Linsenebene verschiebbar ist) möglichst groß ist.

Bekannt sind zu diesem Zweck sogenannte "variable axis"-Linsen (H. C. Pfeiffer und G. O. Langner, J. Vac. Sci. Technol., 1983, Seite 3 - 14). Bei ihnen wird dem Feld einer Rundlinse dynamisch ein geeignetes Korrekturfeld überlagert, das die Position des Schreibfleckes bestimmt. Als nachteilig erweist sich jedoch, daß der nutzbare Arbeitsbereich dieser Linsen durch den Bohrungsradius der Polschuhe begrenzt ist, welcher von der Größenordnung der Brennweite ist. In der Praxis ergeben sich somit Schreibbereiche mit Durchmessern im Bereich eines Millimeters. Um integrierte Schaltungen gebräuchlicher Größenordnung oder gar einen gesamten Wafer bearbeiten zu können, benötigen herkömmliche Lithographieanlagen daher neben der Elektronenoptik einen Tisch mit Werkstückhalterungen, der in einer Ebene senkrecht des Elektronenstrahls beweglich ist. Die Leistungsfähigkeit wird in diesem Fall durch die mechanischen Parameter des Tisches begrenzt, wobei die minimale Größe der erzeugbaren Strukturen von der Führungsgenauigkeit abhängt und die Bewegungsgeschwindigkeit des Tisches die maximale Schreibgeschwindigkeit bestimmt.

Weiterhin sind im Stande der Technik sowohl elektrostatische als auch magnetische Zylinderlinsen zur Fokussierung von Elektronen bekannt (H. Rose, Optik 36, 1972, Seite 19 - 36). Zylinderlinsen sind mit Elektroden bzw. Polschuhen versehen, die zur Führung des elektrischen bzw. magnetischen Feldes dienen, und zwischen denen sich eine spaltförmige Öffnung befindet, durch welche die möglichen Trajektorien geladener Teilchen in der Linse verlaufen. Dabei ist die Längsachse der spaltförmigen Öffnung senkrecht zur optischen Achse der Linse ausgerichtet; die durch optische Achse und Längsachse aufgespannte Ebene wird im folgenden als Mittelebene bezeichnet. Zur stigmatischen Abbildung, d. h. zur punktförmigen Abbildung punktförmiger Elektronenquellen und parallel einfallender Strahlen, sind Zylinderlinsen jedoch ungeeignet, da sie lediglich senkrecht zur Spaltrichtung fokussieren, während Bewegungskomponenten der Teilchen parallel der Spaltrichtung unbeeinflußt bleiben. Somit entstehen stabförmige, astigmatische Punktbilder, die für lithographische Zwecke unzureichend sind.

Schließlich läßt sich die Bewegung geladener Teilchen auch durch Quadrupolfelder beeinflussen. Senkrecht zu seiner Ebene wirkt ein magnetischer Quadrupol dabei gleichfalls als Linse. Gebräuchliche Abbildungen lassen sich auf diese Weise jedoch nicht erzeugen, da der Einfluß einer Quadrupollinse auf ein ebenes, paralleles Strahlenbündel von dessen Winkelstellung zum Magnetfeld abhängt. Während die Quadrupollinse in einer Ebene, welche die optische Achse umfaßt, Parallelstrahlen fokussiert, wirkt sie in der dazu senkrechten, die optische Achse umfassenden Ebene defokussierend auf ein Parallelstrahlbündel. Lediglich der Betrag der Brennweiten läßt sich in beiden Ebenen gleich einstellen. Aufgrund dieser Eigenschaften sind Quadrupollinsen für gebräuchliche optische Abbildungen ungeeignet.

Vor diesem Hintergrund hat sich die Erfindung die Entwicklung einer Linsenanordnung zur Aufgabe gestellt, bei der die Öffnungen für den Elektronenstrahl in einer Dimension von beliebiger Länge sind und die eine stigmatische Abbildung erzeugt.

Diese Aufgabe wird erfindungsgemäß dadurch gelöst, daß die Zylinderlinse mit einer magnetischen Linse kombiniert ist, mit der ein Quadrupolfeld erzeugbar ist, die Linsen in geringem oder ohne Abstand voneinander angeordnet sind und ihre optischen Achsen parallel zueinander verlaufen, die Quadrupollinse eine spaltförmige Öffnung aufweist, die parallel zur Öffnung der Zylinderlinse ausgerichtet ist, die fokussierende, die optische Achse umfassende Ebene der Quadrupollinse parallel der Längsachsen der Öffnungen sowie ihre defokussierende Ebene senkrecht der Längsachsen ausgerichtet ist und die Brechkraft der Zylinderlinse doppelt so groß wie die Brechkraft der Quadrupollinse einstellbar ist.

Der Kerngedanke der Erfindung besteht darin, eine Zylinderlinse mit einer magnetischen Quadrupollinse zu kombinieren, wobei der Begriff Quadrupollinse im Sinne der Erfindung sämtliche Linsen umfaßt, mit denen Felder von Quadrupolsymmetrie erzeugbar sind, etwa auch achtpolige Linsen. Dabei verlaufen die optischen Achsen beider Linsen parallel zueinander und ihre Hauptebenen stimmen überein oder weisen allenfalls einen geringen Abstand voneinander auf. Der Begriff "gering" ist in dem Sinne zu verstehen, daß der Abstand klein gegen die Brennweite beider Linsen ist und die Linsenanordnung in guter Näherung durch eine Einzellinse beschreibbar ist. Die Quadrupollinse weist zwischen ihren Polschuhen eine spaltförmige Öffnung auf, die parallel zur Öffnung der Zylinderlinse ausgerichtet ist, wobei die Länge beider Öffnungen beliebig ist. Die Projektionen beider Öffnungen in Richtung der optischen Achse stimmen vorzugsweise überein. Die Ausrichtung der Quadrupollinse erfolgt in der Weise, daß ihre fokussierende Ebene parallel der Längsachse der Öffnungen und ihre defokussierende Ebene senkrecht der Längsachsen verläuft. Die Brechkraft der Zylinderlinse wird zweckmäßig doppelt so groß wie die des Quadrupols gewählt.

In Folge dieses Aufbaus entsteht durch die Quadrupollinse eine fokussierende Wirkung in der Ebene des Spaltes, wobei die Brennweite gleich der doppelten Brennweite der Zylinderlinse ist. Senkrecht der Spaltrichtung wird die negative Brechkraft des Quadrupols durch die doppelt so große Brechkraft der Zylinderlinse überkompensiert. Im Ergebnis ergibt sich damit eine Brennweite, die ebenfalls gleich der doppelten Brennweite der Zylinderlinse ist. Das Resultat ist folglich eine stigmatisch fokussierende Linse. Entscheidend ist für die Abstimmung der Linsenbrennweiten ausschließlich, daß die Summe der Brechkräfte der Quadrupollinse senkrecht der Spaltlängsachse und der Zylinderlinse gleich der Brechkraft der Quadrupollinse parallel der Spaltlängsachse ist.

Der Vorteil der Linsenanordnung besteht darin, daß Begrenzungen des Strahlverlaufes, wie sie bei Rundlinsen durch den Bohrungsradius der Polschuh bestehen, in Richtung des Spaltes aufgehoben bzw. erheblich reduziert sind. Trotzdem gestattet die Anordnung eine herkömmlichen Rundlinsen vergleichbare, stigmatische Abbildung. Insbesondere treten keine optischen Fehler der Linse auf, die niedriger als von dritter Ordnung sind. Zweckmäßig verläuft bei der Mehrzahl der Anwendungsfälle die optische Achse der Quadrupollinse in der Mittelebene der Zylinderlinse. Weiterhin erweist es sich als von wesentlichem Vorteil, daß entlang des Spaltes unter Vernachlässigung von Einflüssen der endseitigen Spaltränder weitgehende Translationssymmetrie besteht. Daher sind die Abbildungseigenschaften unabhängig von der Lage der optischen Achse der Quadrupollinse bezüglich der Längsachse des Spaltes. Bei geeigneter Anpassung der Linsenparameter, insbesondere der Feldstärken, lassen sich Abbildungen selbstverständlich auch mit beliebigen anderen geladenen Teilchen erzeugen, beispielsweise Ionen, die etwa zur Dotierung von Halbleitern verwendbar sind. Schließlich ist für spezielle Anwendungsfälle denkbar, daß die Abstimmung der Linsenbrennweiten von der oben beschriebenen Einstellung abweicht, etwa um auf einem Werkstück mit astigmatischem Brennfleck strichförmige Strukturen zu erzeugen.

Eine bevorzugte Quadrupollinse besteht aus einer Öffnung, auf oder an deren Rändern stromdurchflossene Leiter verlaufen. Die Leiter sind etwa parallel der optischen Achse ausgerichtet. Zweckmäßig handelt es sich bei den Leitern um auf ein Joch gewickelte Spulen. Die Leiter oder Wicklungen verlaufen an den inneren Rändern der Öffnung, die der optischen Achse zugewandt sind, vorzugsweise ohne Steigung, d. h. im Rahmen der Produktionsgenauigkeit exakt parallel der optischen Achse, um Verzerrungen der Felder zu vermeiden. Auf einander gegenüberliegenden Rändern der Öffnung ist die Richtung der Ströme parallel, während der Stromfluß auf dazu senkrechten Rändern entgegengesetzt gerichtet ist. Vorzugsweise ist die Summe aller Ströme durch die Öffnung Null, um geschlossen umlaufende Magnetfeldlinien zu vermeiden, wobei sich die Stromdichten auf den kurzen und langen Rändern der spaltförmigen Öffnung umgekehrt proportional zu den Randlängen verhalten. Wird die Öffnung in einen Werkstoff eingebracht, etwa von einem Joch umschlossen, dessen magnetische Permeabilität sehr viel größer als eins ist, z. B. Eisen, reduziert sich die zur Erzeugung der Felder notwendige Stromstärke.

Als einfachste Möglichkeit zur Realisierung der notwendigen Translationssymmetrie in Spaltrichtung wird vorgeschlagen, daß die Öffnungen rechteckige Querschnitte aufweisen. In Folge der spaltförmigen Gestalt unterscheiden sich die beiden Kantenlängen des Rechteckes dabei erheblich.

In einer vorteilhaften Ausgestaltung der Erfindung ist die optische Achse der Quadrupollinse parallelverschiebbar. Sie läßt sich also derart in ihrer Lage verändern, daß die parallele Ausrichtung zur Mittelebene der Zylinderlinse stets erhalten bleibt. Bei großer Länge der Spalte oder geeigneter Kompensation von Randeffekten bleiben die Abbildungseigenschaften der Linsenanordnung nahezu unbeeinflußt, wenn sich die Lage der optischen Achse der Quadrupollinse entlang der Längsachse des Spaltes ändert. Denkbar ist jedoch auch, die optische Achse der Quadrupollinse senkrecht oder in beliebigem Winkel zur Spaltlängsachse zu verschieben, also ihren Abstand von der Mittelebene der Zylinderlinse zu verändern.

Zum Zweck der Verschiebung der optischen Achse der Quadrupollinse bietet es sich an, dem Quadrupolfeld ein magnetisches Dipolfeld zu überlagern. Dipolfelder parallel der Spaltrichtung erzeugen dabei Verschiebungen der optischen Achse senkrecht zum Spalt, während Dipolfelder senkrecht der Spaltrichtung die optische Achse in Richtung der Spaltlängsachse verschieben. Bei Erzeugung des Dipolfeldes durch elektrische Ströme ist die kontinuierliche Verschiebung der optischen Achse um beliebige Beträge möglich, indem die Stärke des Erregerstroms variiert wird. Zweckmäßig sind dem Quadrupolfeld zwei zueinander und zur optischen Achse orthogonale Dipolfelder überlagerbar, was die beliebige Verschiebung über die gesamte Fläche des Spaltquerschnittes gestattet.

Zur Erzeugung des Dipolfeldes sind gegenüberliegende Ränder der Öffnung vorzugsweise mit Leitern versehen, welche sich mit Strömen beaufschlagen lassen, die auf beiden Rändern entgegengesetzt und von gleichem Betrag sind. Es ist möglich, daß die Öffnung zu diesem Zweck spezielle Leiter bzw. Windungen aufweist. Alternativ lassen sich diejenigen Leiter verwenden, welche zur Erzeugung des Quadrupolfeldes dienen. Im letzteren Fall summieren sich die Stromflüsse in einzelnen Leitern bzw. heben sich zum Teil auf, so daß im Ergebnis die Gesamtströme auf gegenüberliegenden Rändern voneinander abweichen.

Weiterhin ist es von Vorteil, wenn dem Quadrupolfeld elektrische oder magnetische Multipolfelder höherer Ordnung überlagerbar sind. Zu diesem Zweck sind die Öffnungsränder der Quadrupollinse vorzugsweise mit Leitern bzw. Wicklungen versehen, deren Flächendichte entlang einzelner Randabschnitte variiert. Mittels dieser, i. a. zusätzlichen Leiter lassen sich dem Quadrupolfeld bei entsprechender Anordnung beliebige magnetische Multipolfelder höherer Ordnung überlagern. Sie dienen dazu, Öffnungsfehler der Linse zu korrigieren, wobei die Korrekturfelder in der Regel erheblich schwächer sind als die Di- und Quadrupolfelder.

Um einen Abstand zwischen Zylinder- und Quadrupollinse zu vermeiden wird vorgeschlagen, die Quadrupollinse im Inneren der Zylinderlinse anzuordnen. Im allgemeinen besteht eine Zylinderlinse aus mehreren, voneinander beabstandeten Polschuhpaaren oder Elektroden. Diese Teile lassen sich der Quadrupollinse in Richtung der optischen Achse vor- und nachordnen.

Bei einer bevorzugten Weiterbildung der Erfindung bestehen auch die Polschuhe bzw. Elektroden der Zylinderlinse aus einem Werkstoff hoher magnetischer Permeabilität. In der Folge begrenzen sie das magnetische Feld der Quadrupollinse in Richtung der optischen Achse, wobei eine beidseitige Begrenzung erfolgt, sofern sich die Quadrupollinse im Inneren der Zylinderlinse befindet. Von besonderem Vorteil sind dabei plattenförmige Polschuhe bzw Elektroden der Zylinderlinse, deren Oberflächen senkrecht der optischen Achse verlaufen. Auf diese Weise wird eine Störung der Symmetrie des Quadrupolfeldes vermieden.

Als Zylinderlinsen haben sich sowohl elektrostatische Linsen als auch magnetische Linsen bewährt. Eine elektrostatische Linse besteht aus mehreren, beispielsweise drei, in Richtung der optischen Achse aufeinanderfolgenden Elektroden mit jeweils einer spaltförmigen Öffnung. Dabei unterscheidet sich das elektrische Potential aufeinanderfolgender Öffnungen. Um einen einfachen und kompakten Aufbau der Linsenanordnung zu erreichen wird vorgeschlagen, daß eine der Elektroden von den Oberflächen der Polschuhe der Quadrupollinse gebildet wird. Bei einer Zylinderlinse mit drei Elektroden bildet die Quadrupollinse vorzugsweise die mittlere Elektrode. Zweckmäßig wird dabei nicht der gesamte Polschuh mit der Elektrodenspannung beaufschlagt, sondern seine Oberfläche mit einer ihm gegenüber isolierten Elektrode versehen.

Liegen im Fall einer elektrostatischen Linse die endseitigen Elektroden auf unterschiedlichen Potentialen, so ergibt sich eine Immersionslinse, welche die kinetische Energie der durchlaufenden Teilchen verändert. Diese Ausbildung erweist sich speziell dann als vorteilhaft, wenn eine niedrige Teilchenenergie im Bildraum vorgesehen ist.

Eine erhebliche Erweiterung des Anwendungsbereiches ergibt sich, wenn die Quadrupollinse mit einem elektrischem Feld senkrecht zur optischen beaufschlagbar ist. Auf diese Weise lassen sich zusätzliche Kraftwirkungen auf die Elektronen ausüben und insbesondere ein Wienfilter für Elektronen herstellen. Im Stande der Technik bekannte Wienfilter bestehen aus zueinander senkrechten elektrostatischen und magnetischen Feldern und bewirken eine Richtungsfokussierung, wobei der Ort des Bildes von der kinetischen Energie der geladenen Teilchen abhängt. Entsprechend dienen Wienfilter in Verbindung mit Blenden oder Ablenkvorrichtungen zur Erzeugung monochromatischer Elektronenstrahlen. Im Fall der erfindungsgemäßen Linsenanordnung ist das elektrische Feld senkrecht der Längsachse des Spaltes ausgerichtet, das magnetische Dipolfeld parallel der Längsachse. Die Richtung der Felder ist derart gewählt, daß die Kräfte auf bewegte, geladene Teilchen entgegengesetzt sind, wobei im Fall einer vorgegebenen Teilchengeschwindigkeit eine Kompensation beider Kraftfelder erfolgt. Als vorteilhaft zeigt sich, daß die resultierende Kraft im Spalt entlang der gesamten Mittelebene konstant ist. Die Dispersion ist durch Verändern des elektrischen bzw. magnetischen Feldes stufenlos einstellbar.

Besonders bevorzugt ist die vorgeschlagene Linsenanordnung zu Zwecken der Elektronen- oder Ionenstrahl-Lithographie. In diesem Fall ist sie in der Weise auf ein Werkstück ausgerichtet, daß sich ihr Brennpunkt an seiner Oberfläche befindet. Ein von einer Ladungsträgerquelle erzeugter Parallelstrahl wird somit auf die Oberfläche fokussiert. Das Werkstück, insbesondere ein Wafer aus Halbleitermaterial, ist in einer Halterung befestigt, die senkrecht zu Spaltrichtung und optischer Achse verschiebbar ist. Der Vorteil gegenüber im Stande der Technik gebräuchlichen Ausführungen mit Rundlinsen besteht darin, daß eine mechanische Bewegung der Halterung lediglich in einer Dimension notwendig ist. Die Verwendung einer zweidimensional beweglichen Halterung ist jedoch nicht ausgeschlossen. Die Verschiebung des Brennpunktes auf der Werkstückoberfläche in Spaltrichtung läßt sich durch eine Achsenverschiebung der Quadrupollinse realisieren, etwa durch Überlagerung eines Dipolfeldes. In dazu senkrechter Richtung wird weiterhin eine mechanische Verschiebung des Werkstückes vorgenommen. Dennoch ergeben sich bei rasterartiger Führung des Elektronenstrahls über die Oberfläche erhebliche Vorteile. Die Begründung liegt darin, daß bei zeilenweisem Rastern eine rasche Bewegung des Strahls in Zeilenrichtung erforderlich ist, während ein Zeilenwechsel ausschließlich am Ende der Zeilen erfolgt. Die Bewegung beim Zeilenwechsel kann aufgrund des geringen zurückzulegenden Weges erheblich langsamer vorgenommen werden. Somit verringern sich die Anforderungen an die Bewegungsgeschwindigkeit und -strecke der Werkstückhalterung insbesondere dann, wenn die Längsachse des Spaltes in Richtung der Zeilen des Rasters verläuft. Eine erhebliche Beschleunigung des Bearbeitungsvorganges sowie eine verbesserte Führungsgenauigkeit sind die vorteilhafte Folge.

Weitere Einzelheiten, Merkmale und Vorteile der Erfindung lassen sich dem nachfolgenden Beschreibungsteil entnehmen, in dem ein Ausführungsbeispiel anhand der Zeichnung näher erläutert ist. Die Zeichnung zeigt in prinzipienhafter Darstellung
- Figur 1:: Längsschnitt durch die Linsenanordnung,
- Figur 2:: Querschnitt durch die Linsenanordnung entlang der Linie A-A.

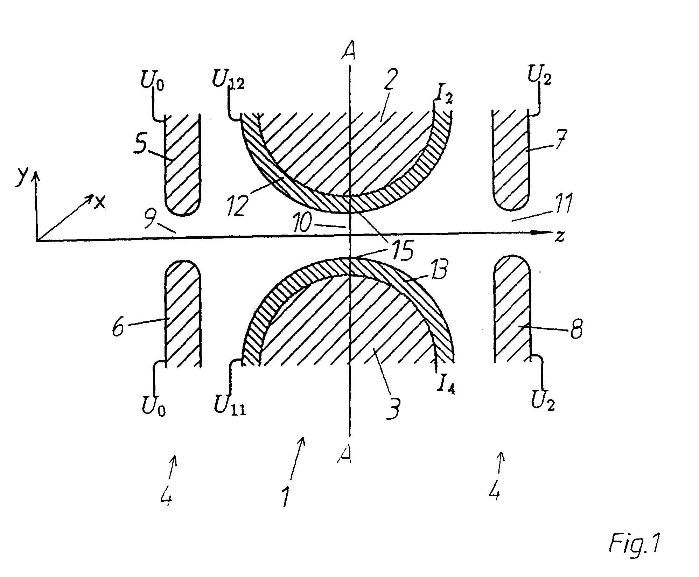

In Figur 1 ist der Querschnitt durch eine Linsenanordnung gezeichnet, die aus einer Quadrupollinse (1) mit den Polschuhen (2, 3) sowie einer Zylinderlinse (4) besteht, welche neben plattenförmigen Elektroden (5 - 8) auch die Polschuhe (2, 3) als weitere Elektrode umfaßt. Zwischen den Polschuhen (2, 3) bzw. den Elektoden (5 - 8) befinden sich jeweils Öffnungen (9 - 11), die in Richtung der Z-Achse, welche parallel der optischen Achse von Quadrupollinse (1) und Zylinderlinse (4) verläuft, miteinander fluchten. Senkrecht der optischen Achse weisen die Öffnungen (9 - 11) einen spaltförmigen Querschnitt auf, wobei die Längsachse des Spaltes in Koordinatenrichtung X senkrecht der Bildebene ausgerichtet ist.

Indem sich die Elektroden (5 - 8) bzw. Oberflächen der Polschuhe (2, 3) der Zylinderlinse (4) auf unterschiedlichen elektrischen Potentialen U0, U1, U2 befinden, wird ein in Richtung der Z-Achse einfallender Parallelstrahl auf eine zur X-Achse parallele Linie in der XZ-Ebene, welche die Mittelebene der Zylinderlinse (4) bildet, fokussiert. Die Oberflächen der Polschuhe (2, 3) sind zu diesem Zweck gleichfalls mit dünnen, isolierten Elektroden versehen. Um symmetrische Abbildungseigenschaften zu gewährleisten ist, besteht dabei eine Spiegelsymmetrie der Polschuhe (2, 3) und Elektroden (5 - 8) zur XY-Ebene. In X-Richtung ausgedehnte Wellenfronten erfahren dagegen keine Fokussierung in der XZ-Ebene durch die Zylinderlinse (4).

Die Fokussierung innerhalb der XZ-Ebene wird mit der magnetischen Quadrupollinse (1) erzeugt, die auf der Oberfläche ihrer Polschuhe (2, 3) elektrische Leiter (12, 13) aufweist, welche parallel der Z-Achse verlaufen. Zweckmäßig handelt es sich bei den Leitern um Wicklungen auf den Polschuhen, deren Liniendichte in X-Richtung konstant ist und die auf der Seite der Polschuhe (2, 3), welche der Z-Achse zugewandt sind, vorzugsweise ohne Steigung, also im Rahmen der Produktionsgenauigkeit exakt parallel der Z-Achse liegen, so daß keine Verzerrung der durch sie erzeugten magnetischen Felder entsteht.

Während die Quadrupollinse (1) in Richtung der Z-Achse einfallende Elektronenstrahlen in der XZ-Ebene fokussiert, ist ihre Brechkraft in der YZ-Ebene negativ, d. h. sie wirkt auf einfallende Parallelstrahlen als Zerstreuungslinse defokussierend. Um die stigmatische Abbildung auf Punkte der Bildebene zu ermöglichen, ist es daher erforderlich, daß die Brechkraft der Zylinderlinse (4) die der Quadrupollinse (1) übersteigt, so daß im Zusammenwirken beider auch in der YZ-Ebene eine Fokussierung erfolgt. Eine stigmatische Fokussierung ergibt sich, wenn die Brechkraft der Zylinderlinse (4) doppelt so groß wie die des Quadrupols ist, da die Kombination beider Linsen in diesem Fall sowohl in der XZ- als auch in YZ-Ebene eine fokussierende Wirkung mit der einfachen Brechkraft des Quadrupols hat.

Zweckmäßig bestehen neben den Polschuhen (2, 3) auch die Elektroden (5 - 8) aus einem Material hoher magnetischer Permeabilität, so daß sie das magnetische Quadrupolfeld begrenzen. Aufgrund der plattenförmigen Ausbildung und Ausrichtung senkrecht der Z-Achse erfolgt keinerlei Störung der Feldsymmetrie. In bezug auf ihre Wirkung als Bestandteile der Zylinderlinse (4) können die Elektrodenpaare (5, 6) und (7, 8) sowohl auf gleichem, elektrischem Potential liegen (UO = U2) als auch unterschiedliche Potentiale aufweisen. Im letzteren Fall ist die Zylinderlinse (4) eine Immersionslinse.

Werden die Elektroden (5 - 8) durch magnetische Polschuhe ersetzt, bei denen das magnetische Potential in den Öffnungen (9, 11) von Null verschieden ist, so entsteht eine magnetische Zylinderlinse (4), die in gleicher Weise mit der Quadrupollinse (1) zusammenwirkt. In diesem Fall verlaufen die Trajektorien der Elektronen durch drei zueinander parallele Schlitze, von denen der erste und letzte die Zylinderlinse bilden, während die mittlere Öffnung (10) die Quadrupollinse ist. Sind die Potentiale in den endseitigen Öffnungen (9, 11) identisch, so kompensieren sich die Lamordrehungen der Elektronen durch beide Teile der Zylinderlinse (4) in erster Ordnung.

Schließlich ist es möglich, die Polschuhe (2, 3), bzw. Elektroden auf ihrer Oberfläche, anstelle einer einheitlichen Spannung U1 durch unterschiedliche Spannungen U11, U12 zu beaufschlagen, die ein elektrisches Feld in Richtung der Y-Achse erzeugen. Durch ein dazu gekreuzt stehendes magnetisches Dipolfeld in X-Richtung wird im Ergebnis ein Wienfilter für Elektronen erzeugt, das eine Richtungsfokussierung bewirkt, die von der kinetischen Energie abhängig ist. Die Felder sind in diesem Fall derart gerichtet, daß ihre Kraftwirkungen auf die bewegten Teilchen einander kompensieren. Die Sollenergie des Wienfilters erzeugt vorzugsweise eine Fokussierung auf die Z-Achse. Durch Veränderung der Spannungen Ull, U12 ist die Filterdispersion stufenlos einstellbar.

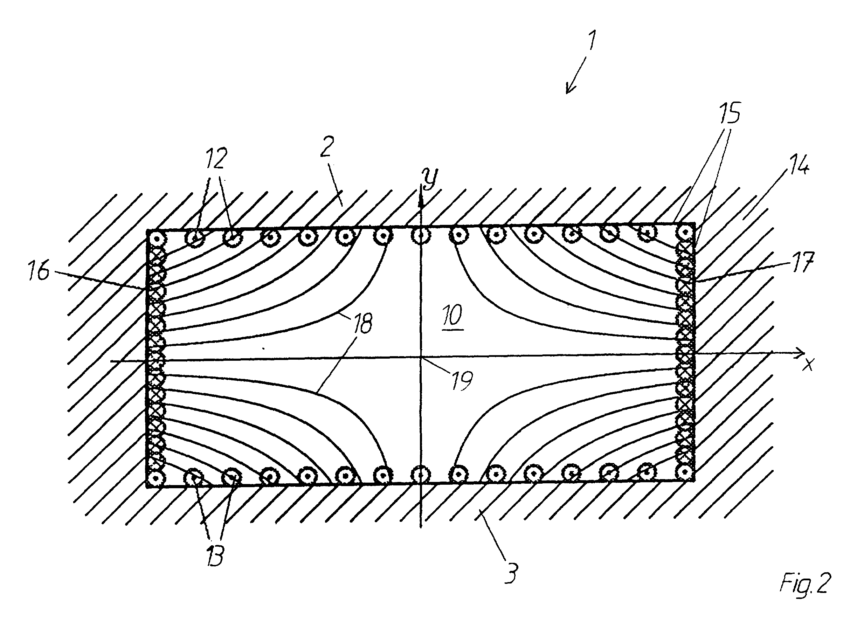

Figur 2 zeigt einen Querschnitt entlang der Linie A-A durch die Quadrupollinse (1) in Figur 1. Dabei ist die Öffnung (10) der Quadrupollinse umlaufend von einem Werkstoff (14) hoher Permeabilität umgeben, der auf der Ober- und Unterseite der Öffnung (10) die Polschuhe (2, 3) bildet. Die Ränder (15) der Öffnung (10) sind mit elektrischen Leitern (12, 13, 16, 17) belegt, in denen der Stromfluß senkrecht der Bildebene, also in Z-Richtung erfolgt. Der Stromfluß durch die Leiter (12, 13) am oberen und unteren Rand (15) ist dabei aus der Bildebene heraus gerichtet, während der Fluß in den Leitern (16, 17) am linken und rechten Rand (15) in die Bildebene hinein erfolgt. Der Gesamtstrom auf jedem Rand (15) der Öffnung (10) ist dabei gleich, so daß die Stromdichte auf geraden Randabschnitten umgekehrt proportional zu ihrer Länge und die Summe sämtlicher Ströme durch die Öffnung (10) somit Null ist. Im Ergebnis entsteht ein magnetisches Quadrupolfeld, dessen Verlauf durch die Äquipotentiallinien (18) dargestellt ist.

Werden die Leiter (12, 13) bzw. (16, 17) auf gegenüberliegenden Rändern (15) zusätzlich mit entgegengesetzt gleichgroßen Strömen beaufschlagt, so entsteht ein magnetisches Dipolfeld, das sich dem Quadrupolfeld überlagert. Die Überlagerung des Dipolfeldes mit dem Quadrupolfeld ergibt eine Verschiebung des letzteren, wobei sich beliebige Verschiebungen erzeugen lassen, indem ggf. verschiedene Zusatzströme in den Leitern (12, 13) und in den Leitern (16, 17) zwei zueinander senkrechte Dipolkomponenten erzeugen. Speziell im Fall einer in X-Richtung langgestreckten, spaltförmigen Öffnung (10) läßt sich die optische Achse der Linsenanordnung mit der optischen Achse (19) des Quadrupols entlang der Spaltlängsachse verschieben, ohne daß sich die Abbildungseigenschaften verändern.

Zusammenfassend entsteht eine stigmatisch abbildende Elektronenoptik mit spaltförmigem Öffnungsquerschnitt, deren optische Achse sich durch Anlegen eines magnetischen Dipolfeldes auf einfache Weise entlang des Spaltes verschieben läßt.

## Patentansprüche

1. Linsenanordnung, insbesondere zur Fokussierung von Elektronen, mit einer Zylinderlinse, welche mit Polschuhen oder Elektroden versehen ist, zwischen denen eine Öffnung befindlich ist, die einen spaltförmigen Querschnitt senkrecht der optischen Achse der Linse aufweist, **dadurch gekennzeichnet**, daß
- die Zylinderlinse (4) mit einer magnetischen Linse (1) kombiniert ist, mit der ein Quadrupolfeld erzeugbar ist,
- die Linsen in geringem oder ohne Abstand voneinander angeordnet sind und ihre optischen Achsen parallel zueinander verlaufen,
- die Quadrupollinse (1) eine spaltförmige Öffnung (10) aufweist, die parallel zur Öffnung (9 - 11) der Zylinderlinse (4) ausgerichtet ist,
- die fokussierende, die optische Achse (19) umfassende Ebene der Quadrupollinse (1) parallel der Längsachsen der Öffnungen (9 - 11) sowie ihre defokussierende Ebene senkrecht der Längsachsen ausgerichtet ist
- und die Brechkraft der Zylinderlinse (4) doppelt so groß wie die Brechkraft der Quadrupollinse (1) einstellbar ist.

2. Linsenanordnung nach Anspruch 1, **dadurch gekennzeichnet**, daß die Quadrupollinse (1) von einer Öffnung (10) in einem Werkstoff (14) hoher magnetischer Permeabilität gebildet wird, an deren Rändern (15) stromdurchflossene Leiter (12, 13, 16, 17) parallel der optischen Achse (19) verlaufen, wobei der Stromfluß in den Leitern (12, 13, 16, 17) auf gegenüberliegenden Rändern (15) parallel und auf den dazu senkrechten Rändern (15) entgegengesetzt gerichtet ist.

3. Linsenanordnug nach Anspruch 1 oder 2, **dadurch gekennzeichnet**, daß die Öffnungen (9 - 11) einen rechteckigen Querschnitt aufweisen.

4. Linsenanordnung nach einem der vorhergehenden Ansprüche, **dadurch gekennzeichnet**, daß die optische Achse (19) der Quadrupollinse (1) parallelverschiebbar ist.

5. Linsenanordnung nach Anspruch 4, **dadurch gekennzeichnet**, daß dem Quadrupolfeld ein magnetisches Dipolfeld überlagerbar ist.

6. Linsenanordnung nach Anspruch 5, **dadurch gekennzeichnet**, daß gegenüberliegende Ränder (15) der Öffnung (10) der Quadrupollinse (1) mit Leitern (12, 13, 16, 17) versehen sind, die mit Strömen beaufschlagbar sind, welche auf beiden Rändern (15) entgegengesetzt und gleich groß sind.

7. Linsenanordnung nach einem der vorhergehenden Ansprüche, **dadurch gekennzeichnet**, daß dem Feld der Quadrupollinse (1) Multipolfelder höherer Ordnung überlagerbar sind.

8. Linsenanordnung nach einem der vorhergehenden Ansprüche, **dadurch gekennzeichnet**, daß die Quadrupollinse (1) in Richtung der optischen Achse im Innern der Zylinderlinse (4) angeordnet ist.

9. Linsenanordnung nach einem der vorhergehenden Ansprüche, **dadurch gekennzeichnet**, daß die Polschuhe und/oder Elektroden (5 - 8) der Zylinderlinse (4) aus einem Werkstoff hoher magnetischer Permeabilität bestehen.

10. Linsenanordnung nach einem der vorhergehenden Ansprüche, **dadurch gekennzeichnet**, daß die Zylinderlinse (4) eine elektrostatische Linse ist.

11. Linsenanordnung nach Anspruch 10, **dadurch gekennzeichnet**, daß die Zylinderlinse (4) aus in Richtung der optischen Achse aufeinanderfolgenden Öffnungen (9 - 11) in Elektroden (5 - 8) besteht, von denen eine Elektrode von den Polschuhen (2, 3) der Quadrupollinse gebildet wird.

12. Linsenanordnung nach Anspruch 10 oder 11, **dadurch gekennzeichnet**, daß die endseitigen Elektroden (5 - 8) der Zylinderlinse (4) unterschiedliche elektrische Potentiale aufweisen.

13. Linsenanordnung nach einem der Ansprüche 1 - 9, **dadurch gekennzeichnet**, daß die Zylinderlinse (4) eine magnetische Linse ist.

14. Linsenanordnung nach einem der vorhergehenden Ansprüche, **dadurch gekennzeichnet**, daß die Quadrupollinse (1) senkrecht ihrer optischen Achse (19) mit einem elektrischem Feld beaufschlagbar ist.

15. Linsenanordnung nach den Ansprüchen 5 und 14, **dadurch gekennzeichnet**, daß das elektrische Feld senkrecht der Längsachse des Spaltes ausgerichtet ist, ein magnetisches Dipolfeld parallel der Längsachse des Spaltes ausgerichtet ist und die Kraftwirkung beider Felder auf bewegte, geladene Teilchen einander entgegengesetzt ist.

16. Linsenanordnung nach einem der Ansprüche 4 - 15, **dadurch gekennzeichnet,** daß der Brennpunkt der Linsenanordnung an der Oberfläche eines Werkstückes liegt, das in einer Werkstückhalterung befestigt ist, die senkrecht zur Längsachse der Öffnungen (9 - 11) verschiebbar ist.

## Claims

1. Lens system, particularly for focusing electrons, with a cylindrical lens with pole shoes or electrodes, between which an aperture is located. This aperture has a slot-shaped cross section perpendicular to the optical axis of the lens, **wherein**
- cylindrical lens (4) is combined with a magnetic lens (1) with which a quadripole field can be produced,
- the lenses are arranged with little or no distance between them and their optical axes run parallel to one another,
- the quadripole lens (1) has a slot-shaped aperture (10) which is oriented parallel to the opening (9-11) of cylindrical lens (4),
- the focusing plane of quadripole lens (1), which comprises the optical axis (19), is oriented parallel to the longitudinal axes of apertures (9-11) and its defocusing plane perpendicularly to the longitudinal axes
- and the refractive power of the cylindrical lens (4) can be set to twice that of quadripole lens (1).

2. Lens system according to claim 1, **wherein** quadripole lens (1) comprises an aperture (10) in a material (14) of high magnetic permeability at whose edges (15) extend current-carrying conductors (12, 13, 16, 17) parallel to optical axis (19), the current flow in conductors (12, 13, 16, 17) on opposing edges (15) being orientated parallel and on the edges (15) perpendicular thereto opposingly.

3. Lens system according to claim 1 or 2, **wherein** apertures (9-11) have a rectangular cross section.

4. Lens system according to one of the preceding claims, **wherein** optical axis (19) can be shifted parallel to quadripole lens (1).

5. Lens system according to claim 4, **wherein** a magnetic dipole field can be superimposed on to the quadripole field.

6. Lens system according to claim 5, **wherein** opposing edges (15) of aperture (10) of quadripole lens (1) are provided with conductors (12, 13, 16, 17), which can be impinged with currents, which on both edges (15) are opposing and of the same magnitude.

7. Lens system according to one of the preceding claims, **wherein** high order multipole fields can be superimposed on to the field of quadripole lens (1).

8. Lens system according to one of the preceding claims, **wherein** quadripole lens (1) is disposed in the direction of the optical axis inside of cylindrical lens (4).

9. Lens system according to one of the preceding claims, **wherein** the pole shoes and/or electrons (5-8) of cylindrical axis (4) comprise a material of high magnetic permeability.

10. Lens system according to one of the preceding claims, **wherein** cylindrical lens (4) is an electrostatic lens.

11. Lens system according to claim 10, **wherein** cylindrical lens (4) comprises successive apertures (9-11) in electrodes (5-8) in the direction of the optical axis where one electrode comprises pole shoes (2, 3) of the quadripole lens.

12. Lens system according to claim 10 or 11, **wherein** the endwise electrodes (5-8) of cylindrical lens (4) have differing electric potentials.

13. Lens system according to one of claims 1 - 9, **wherein** cylindrical lens (4) is a magnetic lens.

14. Lens system according to one of the preceding claims, **wherein** quadripole lens (1) can be impinged with an electric field perpendicularly to its optical axis (19).

15. Lens system according to claims 5 and 14, **wherein** the electric field is orientated perpendicularly to the longitudinal axis of the slot, a magnetic dipole field is orientated parallel to the longitudinal axis of the slot and the dynamic effect of both fields on moved, charged particles is opposed to each other.

16. Lens system according to one of the claims 4 - 15, **wherein** the focal point of the lens system lies on the surface of a workpiece, which is affixed in a workpiece clamping device, which can be displaced perpendicularly to the longitudinal axis of apertures (9-11).

## Revendications

1. Système de lentilles, notamment destiné à la focalisation d'électrons, comprenant une lentille cylindrique, dotée d'épanouissements polaires ou d'électrodes entre lesquels se trouve une ouverture dont la section a la forme d'une fente perpendiculaire à l'axe optique de la lentille, **caractérisé en ce que**
- la lentille cylindrique (4) est combinée à une lentille magnétique (1) permettant de créer un champ quadripôle,
- les lentilles étant rapprochées ou contiguës et leurs axes optiques étant parallèles,
- la lentille quadrupôle (1) présentant une ouverture en forme de fente (10), parallèle à l'ouverture (9 - 11) de la lentille cylindrique (4),
- le plan focalisant, renfermant l'axe optique (19), de la lentille quadrupôle (1) étant parallèle aux axes longitudinaux des ouvertures (9 - 11) et son plan défocalisant étant perpendiculaire aux axes longitudinaux,
- et le pouvoir réfringent de la lentille cylindrique (4) pouvant être le double du pouvoir réfringent de la lentille quadrupôle (1).

2. Système de lentilles selon la revendication 1, **caractérisé en ce que** la lentille quadrupôle (1) est formée par une ouverture (10) réalisée dans un matériau (14) de haute perméabilité magnétique et sur les bords (15) de laquelle se trouvent des conducteurs (12, 13, 16, 17) parallèles à l'axe optique (19), traversés par un courant, le courant passant dans les conducteurs (12, 13, 16, 17) placés sur les bords opposés (15) étant parallèle et le courant passant dans les conducteurs situés sur les bords perpendiculaires (15) étant contraire.

3. Système de lentilles selon la revendication 1 ou 2, **caractérisé en ce que** les ouvertures (9 - 11) présentent une section rectangulaire.

4. Système de lentilles selon l'une des revendications précédentes, **caractérisé en ce que** l'axe optique (19) de la lentille quadrupôle (1) peut être déplacé parallèlement.

5. Système de lentilles selon la revendication 4, **caractérisé en ce qu**'il est possible de superposer un champ dipôle magnétique au champ quadrupôle.

6. Système de lentilles selon la revendication 5, **caractérisé en ce que** les bords opposés (15) de l'ouverture (10) de la lentille quadrupôle (1) sont pourvus de conducteurs (12, 13, 16, 17) dans lesquels on peut faire passer des courants égaux et contraires sur les deux bords (15).

7. Système de lentilles selon l'une des revendications précédentes, **caractérisé en ce qu**'il est possible de superposer des champs multipôles d'ordre supérieur au champ de la la lentille quadrupôle (1).

8. Système de lentilles selon l'une des revendications précédentes, **caractérisé en ce que** la lentille quadrupôle (1) est placée à l'intérieur de la lentille cylindrique (4), dans le sens de l'axe optique.

9. Système de lentilles selon l'une des revendications précédentes, **caractérisé en ce que** les épanouissements polaires et/ou les électrodes (5 - 8) de la lentille cylindrique (4) sont composés d'un matériau de haute perméabilité magnétique.

10. Système de lentilles selon l'une des revendications précédentes, **caractérisé en ce que** la lentille cylindrique (4) est une lentille électrostatique.

11. Système de lentilles selon la revendication 10, **caractérisé en ce que** la lentille cylindrique (4) se compose d'ouvertures (9 - 11) successives dans le sens de l'axe optique, dans des électrodes (5 - 8), l'une de ces électrodes étant formée par les épanouissements polaires (2, 3) de la lentille quadrupôle.

12. Système de lentilles selon la revendication 10 ou 11, **caractérisé en ce que** les électrodes (5 - 8) situées aux extrémités de la lentille cylindrique (4) ont des potentiels différents.

13. Système de lentilles selon l'une des revendications 1 à 9, **caractérisé en ce que** la lentille cylindrique (4) est une lentille magnétique.

14. Système de lentilles selon l'une des revendications précédentes, **caractérisé en ce qu**'il est possible d'appliquer un champ électrique à la lentille quadrupôle (1), perpendiculairement à son axe optique (19).

15. Système de lentilles selon l'une des revendications 5 à 14, **caractérisé en ce que** le champ électrique est perpendiculaire à l'axe longitudinal de la fente, qu'un champ dipôle magnétique est parallèle à l'axe longitudinal de la fente, et en ce que les deux champs exercent des forces opposées sur les particules chargées en mouvement.

16. Système de lentilles selon l'une des revendications 4 - 15, **caractérisé en ce que** le point focal du système de lentilles se trouve à la surface d'une pièce fixée dans un support pouvant se déplacer perpendiculairement à l'axe longitudinal des ouvertures (9 - 11).
